# EUROPÄISCHE PATENTANMELDUNG

(11) **EP 1 995 861 A1**
(43) Veröffentlichungstag der Anmeldung: **26.11.2008**
(21) Anmeldenummer: 07010196.9
(22) Anmeldetag: 23.05.2007
(51) Int. Cl.: H02M 7/00

(54) **Wechselrichter**

(71) Anmelder: SMA Solar Technology AG, 34266 Niestetal (DE)
(72) Erfinder: Victor, Matthias, Dr., 34266 Niestetal (DE); Dach, Manfred, 34305 Niedenstein (DE); Donth, Andreas, 34295 Edermunde (DE); Bremicker, Sven, 36211 Alheim (DE)
(74) Vertreter: Walther, Walther & Hinz GbR

(57) **Zusammenfassung**

Gegenstand der Erfindung ist ein Wechselrichter (1), umfassend ein Gehäuse (8) sowie mindestens einen Gehäusedeckel (2), wobei der Gehäusedeckel (2) in mechanischem Eingriff mit einem Sicherheitsstecker (10) steht, wobei der Sicherheitsstecker (10) in elektrischer Verbindung mit mindestens dem DC-seitigen Laststromkreis steht, wobei nach Entfernen des Sicherheitssteckers aus dem Gehäuse (8) der Wechselrichter von zumindest dem DC-seitigen Laststromkreis abgeschaltet oder getrennt wird.

## Beschreibung

Die vorliegende Erfindung betrifft einen Wechselrichter.

Wechselrichter sind bekannt; Wechselrichter werden insbesondere bei der Erzeugung alternativer Energie, z. B. mit Hilfe von PV Modulen, zur Umwandlung von Gleichstrom in Wechselstrom eingesetzt. Ein Wechselrichter umfasst ein Gehäuse, wobei das Gehäuse die für den Betrieb des Wechselrichters erforderlichen elektronischen Bauelemente aufnimmt und darüber hinaus auch einen Abschnitt zur Aufnahme von Steckern für die Einleitung des beispielsweise von PV-Modulen gelieferten Gleichstroms aufweist. Darüber hinaus besitzt ein solcher Wechselrichter Anschlüsse in das Innere des Gehäuses sowie gegebenenfalls eine sogenannte "Kommunikationseinheit" mit einem Display, wobei auf dem Display beispielsweise angezeigt wird, welche Strommenge momentan produziert wird.

Insbesondere PV-Wechselrichter müssen sowohl mit einem AC-Trennschalter als auch einem DC-Trennschalter ausgerüstet sein. Durch den AC-Trennschalter wird insbesondere bei nicht ausreichender DC-Leistung sichergestellt, dass die Elektronik vom AC-Spannungsnetz getrennt werden kann. Durch den DC-Schalter wird der Nennstrom abgeschaltet. Hierdurch soll sichergestellt werden, dass im Kurzschluss oder Fehlerfall der Wechselrichter jederzeit ohne Lichtbogen von der DC-Quelle, z. B. einem PV-Modul, getrennt werden kann.

Die bekannten Wechselrichter sind mit einem Deckel versehen, wobei bei Abnahme des Deckels Zugang zu der innenliegenden Elektronik besteht, um beispielsweise Reparatur- oder Wartungsmaßnahmen an der Leistungselektronik vornehmen zu können. Bevor nun der Deckel abgenommen wird, um sich Zugang zu der Leistungselektronik zu verschaffen, ist sicherzustellen, dass insbesondere keine gefährlichen DC-Spannungen am Gerät anliegen. Das heißt, es muss sichergestellt sein, dass beim Öffnen des Gerätes der Wechselrichter einerseits sicher vom Netz getrennt ist und andererseits keine DC-Spannungen am Gerät anliegen. Das heißt, die Elektronik muss spannungsfrei sein.

Nach dem Stand der Technik wird dies dadurch erreicht, das nach allgemein anerkannten Sicherheitsregeln wie Freischalten, den Wechselrichter gegen Wiedereinschalten sichern, Spannungsfreiheit feststellen, Erden und Kurzschließen, gegebenenfalls unter Spannung stehende benachbarte Teile abdecken oder abschranken sichergestellt wird, dass tatsächlich insbesondere keine gefährlichen DC-Spannungen am Wechselrichter anliegen. Problematisch hierbei ist, dass die nach den Sicherheitsregeln vorgegebenen Arbeitsabläufe durch die Bedienperson peinlich genau eingehalten werden müssen, um eine Gefährdung solcher Personen auszuschließen. Da den vorgegebenen Sicherheitsregeln nicht immer Folge geleistet wird, kommt es immer wieder zu Unfällen.

Der Erfindung liegt daher die Aufgabe zu Grunde, hier Abhilfe zu schaffen und insbesondere dafür zu sorgen, dass bei Öffnen des Gehäuses des Wechselrichters sichergestellt ist, dass insbesondere keine gefährlichen DC-Spannungen am Wechselrichter anliegen.

Die Aufgabe wird erfindungsgemäß dadurch gelöst, dass bei einem Wechselrichter mit einem Gehäuse mindestens ein Gehäusedeckel vorgesehen ist, wobei der Gehäusedeckel in mechanischem Eingriff mit einem Sicherheitsstecker steht, wobei der Sicherheitsstecker in elektrischer Verbindung mit mindestens dem DC-seitigen Laststromkreis steht, wobei bei Entfernung des Sicherheitssteckers aus dem Gehäuse der Wechselrichter zumindest DC-seitig von dem Laststromkreis getrennt wird. Hieraus wird deutlich, dass durch die mechanische Verriegelung des Deckels durch den Sicherheitsstecker das Gehäuse nicht geöffnet werden kann, wenn nicht der Sicherheitsstecker vorher gezogen wurde. Bei Ziehen des Sicherheitssteckers wird dann ein Schalter aktiviert, mit dem der Wechselrichter zumindest von dem DC-seitigen Laststromkreis abgeschaltet oder getrennt wird.

Vorteilhafte Merkmale zu der Erfindung sowie Ausgestaltungen der Erfindung sind den Unteransprüchen zu entnehmen.

Vorteilhaft ist durch den Stecker der Wechselrichter sowohl DC- als auch AC-seitig mit den Laststromkreisen verbunden. Das heißt, dass bei Ziehen des Sicherheitssteckers der Wechselrichter AC- und DC-seitig von den entsprechenden Laststromkreisen getrennt wird.

So ist insbesondere vorgesehen, dass durch den Sicherheitsstecker zwei Schalter aktivierbar sind, wobei durch einen Schalter der Wechselrichter DC-seitig und durch einen anderen Schalter der Wechselrichter AC-seitig von dem jeweiligen Laststromkreis getrennt wird, so dass kein Strom mehr fließt. Eine Trennung auch von der AC-Seite her ist erforderlich, da durch Kondensatoren in der Leistungselektronik auch noch Ströme fließen können, selbst wenn der Wechselrichter bereits DC-seitig von der Stromquelle abgeschaltet oder getrennt worden ist. Erst dann, also wenn die Trennung von der AC-Seite erfolgt ist, ist der Gleichspannungszwischenkreis spannungslos.

In Bezug auf die mechanische Verriegelung des Gehäusedeckels mit dem Sicherheitsstecker ist im Einzelnen vorteilhaft vorgesehen, dass der Gehäusedeckel gehäuseseitig mindestens eine Öse aufweist, durch die der Sicherheitsstecker ragt. Das heißt, ohne Ziehen des Sicherheitssteckers ist ein Abheben des Deckels unmöglich. Somit ist in jedem Fall sichergestellt, dass bei Abheben des Deckels zum Zugang in das Innere des Gehäuses die innenliegende Elektronik des Gehäuse des Wechselrichters spannungsfrei ist.

Im Einzelnen weist der Sicherheitsstecker einen Steckerkopf und einen Steckerkörper auf, wobei der Steckerkörper durch die mindestens eine Öse des Gehäusedeckels ragt. Durch die Anordnung eines Steckerkopfes ist sichergestellt, dass der Sicherheitsstecker nach außen gut sichtbar ist und auch leicht handhabbar herausziehbar ist.

Nach einem besonderen Merkmal der Erfindung umfasst das Wechselrichtergehäuse mindestens zwei Gehäusekammern, wobei entsprechend mindestens zwei Gehäusedeckel für die Abdeckung der Gehäusekammern vorgesehen sind, wobei der eine erste Gehäusedeckel, der in mechanischem Eingriff mit dem Sicherheitsstecker steht, Befestigungselemente des anderen, zweiten Gehäusedeckels im geschlossenen Zustand abdeckt, so dass der andere, zweite Gehäusedeckel erst nach Entfernung des einen ersten Gehäusedeckels abnehmbar ist. Eine solche Ausgestaltung ist von folgender Überlegung geleitet:

In einem Wechselrichter sind eine ganze Reihe von elektronischen Baugruppen untergebracht, allerdings auch eine Vielzahl von Anschlusssteckern oder Steckerbuchsen, wobei insbesondere für den Anschluss des Wechselrichters der Elektriker, der den Anschluss vornimmt, keinen Zugang zu der Leistungselektronik des Wechselrichters benötigt. Es ist vielmehr ausreichend, wenn für den Elektriker Zugang zu den Anschlüssen und gegebenenfalls zu der Kommunikationseinheit besteht. Hierfür ist - wie bereits oben ausgeführt - vorgesehen, dass der Wechselrichter zwei Gehäusekammern aufweist, wobei in der einen ersten Gehäusekammer vorteilhaft die Anschlusselemente, wie beispielsweise Stecker, Steckerbuchsen und Ähnliches, aber auch elektronische Bauteile untergebracht sind, aber auch z. B. die Kommunikationseinheit, und wobei darüber hinaus in der anderen, zweiten Gehäusekammer die Elektronikbaugruppen des Wechselrichters angeordnet sind, die nur zu Wartungs- oder Reparaturarbeiten zugänglich sein müssen. Im Sinne eines zweistufigen Sicherheitskonzeptes wird nun sichergestellt, dass der andere, zweite Deckel der zweiten Gehäusekammer, die die leistungselektronischen Bauteile aufnimmt, erst dann geöffnet werden kann, wenn der eine erste Deckel nach Ziehen des Sicherheitssteckers entfernt worden ist. Denn durch den ersten Deckel werden - wie bereits ausgeführt - die Befestigungselemente, also beispielsweise Schrauben, die den anderen, zweiten Gehäusedeckel am Gehäuse fixieren, derart abgedeckt, dass diese erst zugänglich sind, wenn der eine erste Gehäusedeckel abgenommen ist.

Anhand der Zeichnungen wird die Erfindung nachstehend beispielhaft näher erläutert.
- Figur 1: zeigt den Wechselrichter mit zwei Gehäusedeckeln in perspektivischer Darstellung;
- Figur 2: zeigt eine Darstellung gemäß Figur 1, bei der der eine erste Gehäusedeckel entfernt ist;
- Figur 3: zeigt in perspektivischer Darstellung den einen ersten Gehäusedeckel;

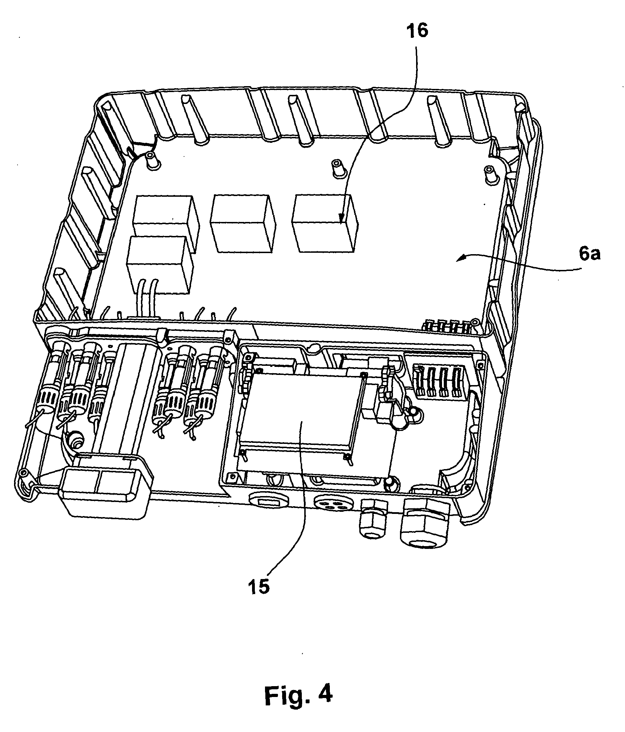

- Figur 4: zeigt das Gehäuse des Wechselrichters gänzlich ohne Gehäusedeckel.

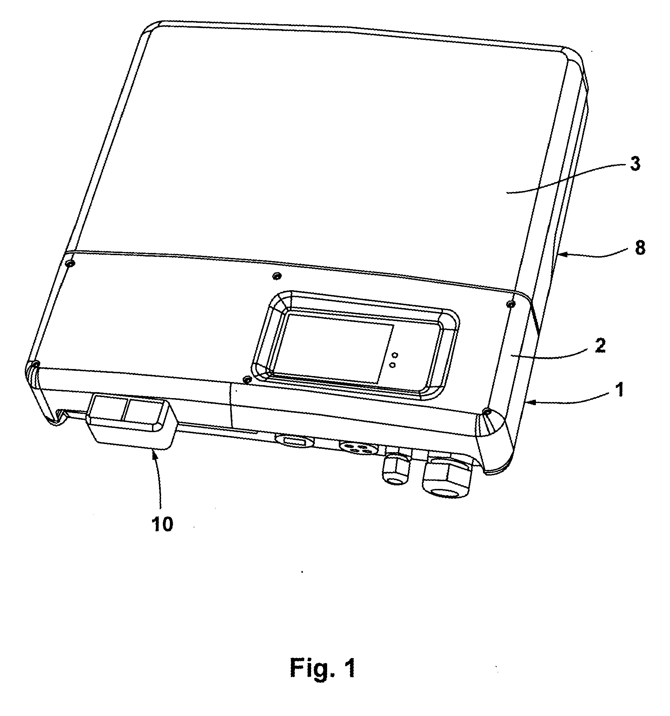

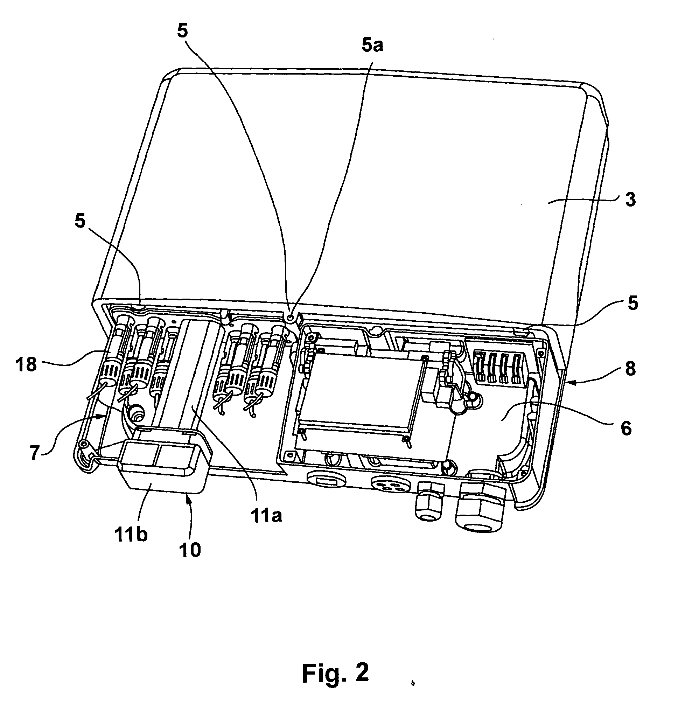

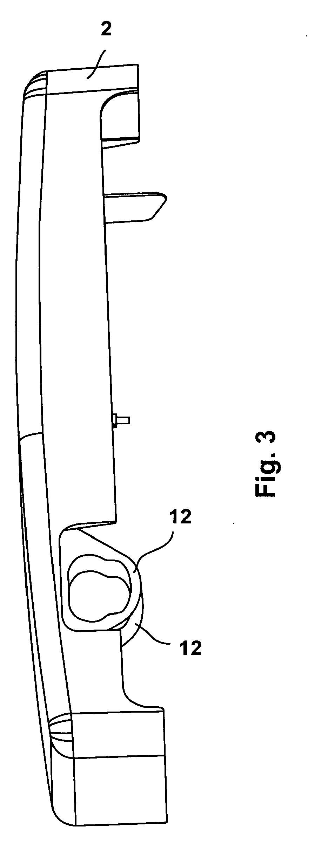

Gemäß Figur 1 weist der mit 1 bezeichnete Wechselrichter mit dem Gehäuse 8 die beiden Gehäusedeckel 2 und 3 auf. Der eine erste Gehäusedeckel 2 ist hierbei durch den mit 10 bezeichneten Sicherheitsstecker gegen Abheben von dem Gehäuse 8 mit der Gehäusekammer 6 derart gesichert, dass erst bei gezogenem Sicherheitsstecker nach Lösen der entsprechenden Schraubverbindungen dieser eine erste Gehäusedeckel 2 abgenommen werden kann (Fig. 2, Fig. 3).

Bei Abnahme des einen ersten Gehäusedeckels 2 ergibt sich eine Darstellung auf den Wechselrichter, wie in Figur 2 gezeigt, wobei der Deutlichkeit wegen der Sicherheitsstecker 10 im gesteckten Zustand allerdings - wie bereits ausgeführt - ohne den einen ersten Gehäusedeckel 2 dargestellt ist. Erkennbar wird durch den einen ersten Gehäusedeckel 2 eine Gehäusekammer 6 des Gehäuses 8 abgedeckt sowie ein weiterer kammerförmiger Anschlussbereich 7 in dem Gehäuse 8, in dem eine Vielzahl von Stecker und Steckerbuchsen 18 vorgesehen sind, allerdings auch - wie bereits ausgeführt - der Sicherheitsstecker 10.

Gegenstand der Erfindung ist nun auch die Sicherung des anderen, zweiten Deckels 3 gegen Abnehmen durch den einen ersten Deckel 2. In diesem Zusammenhang wird darauf hingewiesen, dass der andere, zweite Deckel 3, der die Gehäusekammer 6a abdeckt, mehrere Laschen 5 (Figur 2) aufweist, wobei durch die eine Lasche 5 mittels einer Schraube 5a der andere, zweite Deckel 3 am Gehäuse fixiert wird. Diese Lasche 5 samt der Schraube 5a wird durch den einen ersten Gehäusedeckel 2 genauso abgedeckt, wie die beiden anderen Laschen 5.

Gegenstand der Erfindung ist des Weiteren die Ausgestaltung des Deckels 2 (siehe Figur 3), um diesen einen ersten Deckel 2 gegen Abheben zu sichern, wenn der Sicherheitsstecker 10 sich im eingesteckten Zustand befindet. Erkennbar weist gemäß Figur 3 der eine erste Deckel 2 gehäuseseitig, also auf seiner Innenseite, zwei hintereinander angeordnete Ösen 12 auf, durch die der Stecker 10 mit seinem Steckerkörper 11a im gesteckten Zustand durchragt. Das heißt, ohne ein Ziehen des Sicherheitssteckers 10 am dem Steckerkopf 11 b ist eine Abnahme des Deckels 2 und damit auch ein Zugang zu den elektronischen Bauteilen 16 in der Gehäusekammer 6a, die durch den anderen zweiten Deckel 3 abgedeckt wird, nicht möglich, da - wie bereits an anderer Stelle erläutert - der Deckel 3 durch den Gehäusedeckel 2 gesichert ist.

Das Ziehen des Sicherheitssteckers bewirkt, dass der Wechselrichter DC- und AC-seitig stromlos wird, mithin dann gefahrlos am Wechselrichter gearbeitet werden kann.

## Patentansprüche

1. Wechselrichter (1), umfassend ein Gehäuse (8) sowie mindestens einen Gehäusedeckel (2), wobei der Gehäusedeckel (2) in mechanischem Eingriff mit einem Sicherheitsstecker (10) steht, wobei der Sicherheitsstecker (10) in elektrischer Verbindung mit mindestens dem DC-seitigen Laststromkreis steht, wobei nach Entfernen des Sicherheitssteckers aus dem Gehäuse (8) der Wechselrichter von zumindest dem DC-seitigen Laststromkreis getrennt wird.

2. Wechselrichter nach Anspruch 1,
**dadurch gekennzeichnet,**
**dass** durch den Stecker der Wechselrichter (1) DC- und AC-seitig mit den Laststromkreisen verbunden ist.

3. Wechselrichter nach Anspruch 1,
**dadurch gekennzeichnet,**
**dass** der Gehäusedeckel (2) gehäuseseitig mindestens eine Öse (12) aufweist, durch die der Sicherheitsstecker (10) ragt.

4. Wechselrichter nach einem der voranstehenden Ansprüche,
**dadurch gekennzeichnet,**
**dass** der Sicherheitsstecker (10) einen Steckerkopf (11b) und einen Steckerkörper (11 a) aufweist, wobei der Steckerkörper (11a) durch die mindestens eine Öse (12) des Gehäusedeckels (2) ragt.

5. Wechselrichter nach einem der voranstehenden Ansprüche,
**dadurch gekennzeichnet,**
**dass** das Wechselrichtergehäuse (8) mindestens zwei Gehäusekammern (6, 6a) umfasst, wobei entsprechend mindestens zwei Gehäusedeckel (2, 3) für die Abdeckung der Gehäusekammern (6, 6a) vorgesehen sind, wobei der eine erste Gehäusedeckel (2), der in mechanischem Eingriff mit dem Sicherheitsstecker (10) steht, Befestigungselemente (5, 5a) des anderen, zweiten Gehäusedeckels (3) im geschlossenen Zustand abdeckt, so dass der andere, zweite Gehäusedeckel (3) erst nach Entfernen des einen ersten Gehäusedeckels (2) abnehmbar ist.

6. Wechselrichter nach einem der voranstehenden Ansprüche,
**dadurch gekennzeichnet,**
**dass** die eine erste Gehäusekammer (6) elektrische Anschlusselemente (18), z. B. Stecker, Steckerbuchsen und Ähnliches und/oder elektronische Bauteile aufweist,

7. Wechselrichter nach einem der voranstehenden Ansprüche,
**dadurch gekennzeichnet,**
**dass** die andere, zweite Gehäusekammer (6a) die elektronischen Bauteile (16) des Wechselrichters aufnimmt.

8. Wechselrichter nach einem der voranstehenden Ansprüche,
**dadurch gekennzeichnet,**
**dass** die eine erste Gehäusekammer (6) eine Kommunikationseinheit (15) mit Display aufweist.

## Geänderte Patentansprüche

### Geänderte Patentansprüche gemäss Regel 137(2) EPÜ.

**1.** Wechselrichter (1), umfassend ein Gehäuse (8) sowie mindestens einen Gehäusedeckel (2), wobei der Gehäusedeckel (2) in mechanischem Eingriff mit einem Sicherheitsstecker (10) steht, wobei der Sicherheitsstecker (10) in elektrischer Verbindung mit mindestens dem DC-seitigen Laststromkreis steht, wobei durch Ziehen des Sicherheitssteckers aus dem Gehäuse (8) ein Schalter aktiviert wird, durch den der Wechselrichter von zumindest dem DC-seitigen Laststromkreis getrennt wird.
